# EUROPEAN PATENT APPLICATION

(11) **EP 4 603 848 A1**
(43) Date of publication of application: **20.08.2025**
(21) Application number: 25158642.6
(22) Date of filing: 18.02.2025
(51) Int. Cl.: G01R 15/18, G01R 19/12, H01F 5/00, H01F 27/28, G01R 1/22

(54) **CURRENT SENSOR SYSTEM**

(30) Priority: 19.02.2024 US 202418581219
(71) Applicant: Analog Devices International Unlimited Company, Limerick (IE)
(72) Inventor: Hurwitz, Jonathan Ephraim David, Limerick (IE); Brown, Christopher Thomas, Limerick (IE)
(74) Representative: Horler, Philip John

(57) **Abstract**

The present disclosure relates to a current sensor system (300) for use in measuring an electrical measurand that is dependent on current in a current carrying conductor (380). In one example, the current sensor system comprises a first measurement coil (320) and a second measurement coil (350), wherein the first measurement coil and the second measurement coil are configured for positioning relative to each other and the current carrying conductor so as to at least partially encircle the current carrying conductor. The system also comprises first (330) and second (360) electronic circuits for actively processing sensor signals output from the first and second measurement coils such that the electrical measurand can be measured based on a combination (390) of the first and second actively processed signals.

## Description

### Technical field

The present disclosure relates to system for measuring the current in a conductor, and more particularly systems that use at least two measurement coils for measurement the current in a conductor.

### Backaround

Current sensors detect and measure an electrical current passing through a conductor. They are used in many different applications, for example, to provide accurate current measurement in utility meters.

One type of current sensor uses a shunt resistor in series with the current carrying conductor. The voltage drop across the resistor may be measured and, through knowledge of the resistance of the shunt, the current through the resistor may be calculated. However, at higher currents the temperature of the shunt may increase, changing the resistance of the shunt, and therefore providing an inaccurate current measurement. Further, as the shunt is located directly in the measured current path, isolating circuitry may be required between the shunt and the sensitive measurement and processing electronics.

Another type of current sensor uses an electromagnetic transducer to detect changes in a magnetic field generated by the current carrying conductor. These rate-of-change of field current sensors (sometimes referred to as di/dt current sensors), for example Rogowski coils, do not require any physical connection to the current carrying conductor, and are therefore isolated from the current carrying conductor without the need for any further isolating componentry.

Rate-of-change current sensors can be implemented on a printed circuit board (PCB), for example forming the coil using metal track and vias over two layers of the PCB. The metal track and vias may together form a helical conductor that forms a toroidal shape to surround an opening in the PCB through which the current carrying conductor may pass.

One category of rate-of-change current sensors is a clamp-on sensor. This category is design to enable the sensor to be fitted to an in-situ current carrying conductor, so that the current carrying conductor may be positioned within the central opening of the current sensor. Such clamp-on sensors typically have the sensor coil split into two parts so that there is a gap in the coil to allow the current carrying conductor to path through into the central opening of the sensor. Often, the current sensor is designed so that when the conductor has been put through the gap in the sensor and positioned in the central opening of the sensor, the two parts of the coil can be brought together and clamped together so that the two part of the coil effectively form a single coil that surrounds (or encircles) the conductor. In the example of a PCB implemented rate-of change of current sensor, each of the two parts of the coil may be formed on a separate PCB that are then brought together around the current carrying conductor.

Each part of the clamp-on sensor is typically electrically passively connected together, for example by conductive wires and/or connectors, so that the two parts of the coil can electrically form a single coil with the signals from one summing with the other to make a combined signal that represents the rate of change of current being carried in the conductor that the coils are meant to be measuring. Optionally, the current can be determined from the rate of change signal by integrating it. However, these wires and connectors may introduce asymmetries and irregularities, forming unwanted loops in the effective combined coil that can result in poor electromagnetic field rejection, poor electrostatic coupling and/or crosstalk with neighbouring current sensors or other devices. Consequently, the performance of such clamp-on sensors can be poor.

### Summary

In a first aspect of the disclosure there is provided a current sensor system for use in measuring an electrical measurand that is dependent on current in a current carrying conductor, the current sensor system comprising: a first measurement coil; a second measurement coil, wherein the first measurement coil and the second measurement coil are configured for positioning relative to each other and the current carrying conductor so as to at least partially surround the current carrying conductor; a first electronic circuit comprising a first input coupled to the first measurement coil and a first output for coupling to a measurement circuit, the first electronic circuit being configured to generate a first actively processed signal based on a first sensor signal received from the first measurement coil and output the first actively processed signal from the first output; and a second electronic circuit comprising a second input coupled to the second measurement coil and a first output for coupling to the measurement circuit, the first electronic circuit being configured to generate a second actively processed signal based on a second sensor signal received from the second measurement coil and output the second actively processed signal from the second output, wherein the first actively processed signal and the second actively processed signal are for combining to measure the electrical measurand that is dependent on current in a current carrying conductor.

In a second aspect of the disclosure, there is provided a measurement system for measuring an electrical measurand that is dependent on current in a current carrying conductor, the measurement system comprising: a combining circuit for coupling to a first measurement coil and a second measurement coil that are arranged to at least partially surround the current carrying conductor, wherein the combining circuit is configured to generate a combined signal by combining: a first actively processed signal that is dependent on a first sensor signal output by the first measurement coil; and a second actively processed signal that is dependent on a second sensor signal output by the second measurement coil; and a measurement circuit coupled to the combining circuit, wherein the measurement circuit is configured to measure the electrical measurand based on the combined signal.

In a third aspect of the disclosure, there is provided a utility meter for measuring electrical energy supplied by a current carrying conductor, the utility meter comprising: a first measurement coil; a second measurement coil, wherein the first measurement coil and the second measurement coil are configured for positioning relative to each other and the current carrying conductor so as to at least partially surround the current carrying conductor; a measurement circuit; a first electronic circuit comprising a first input coupled to the first measurement coil and a first output coupled to the measurement circuit, the first electronic circuit being configured to generate a first actively processed signal based on a first sensor signal received from the first measurement coil and output the first actively processed signal from the first output; and a second electronic circuit comprising a second input coupled to the second measurement coil and a first output coupled to the measurement circuit, the first electronic circuit being configured to generate a second actively processed signal based on a second sensor signal received from the second measurement coil and output the second actively processed signal from the second output, wherein the measurement circuit is configured measure the electrical energy based on a combination of the first actively processed signal and the second actively processed signal.

### Drawings

Aspects of the present disclosure are described, by way of example only, with reference to the following drawings, in which:
Figure 1 is a diagram of a known Rogowski coil;
Figure 2A shows a first example of a PCB implemented clamp-on current sensor;
Figure 2B shows the clamp-on current sensor of Figure 2A from a different perspective;
Figure 2C shows an alternative implementation of the clamp-on current sensor of Figures 2A and 2B;
Figure 2D shows an example schematic electrical circuit diagram of the clamp on current sensor of Figure 2A;
Figure 3 shows an example schematic diagram of a system according to an aspect of the present disclosure;
Figure 4 shows a schematic diagram of an alternative implementation of the system of Figure 3;
Figure 5 shows an example schematic electrical circuit diagram of the system of Figure 3;
Figure 6 shows an example schematic electrical circuit diagram showing details of one example implementation of circuit of Figure 5;
Figure 7 shows an example schematic electrical circuit diagram showing details of one alternative example implementation of circuit of Figure 5;
Figure 8 shows an example implementation of a utility meter in accordance with an aspect of the disclosure;
Figure 9 shows an example schematic diagram of a system according to a further aspect of the present disclosure;
Figure 10 shows an example schematic diagram of a system according to a further aspect of the present disclosure;
Figure 11 shows an example schematic diagram of a system according to a further aspect of the present disclosure; and
Figure 12 shows an example schematic diagram of a system according to a further aspect of the present disclosure.

### Detailed Description

Split, or clamp-on, rate of change of current sensors can enable the fitting of a current sensor around a conductor that might not be able to receive a non-split current sensor, but have a number of drawbacks. The main drawback is a reduction in measurement accuracy caused by imperfections/asymmetries in the fitted coil and electro-magnetic noise induced in the electrical interconnections between the two parts of the current sensor coil, and between the two parts of the current sensor coil and a current measurement circuit that determines a measurement of current using the signals output from the current sensor coil. Furthermore, it also increases the cost and complexity of manufacture and installation, since the two parts of the coil need to be electrically connected together, which requires additional componentry and reduced manufacturing tolerances to ensure that they electrically connect with positional accuracy and introduce minimal extra loops that can pick-up undesirable magnetic fields.

To address these issues the inventors have developed a split, or clamp-on, current sensor where each part of the current sensor has an active electronic circuit to process the signal output from that part. For example, if the sensor is split into two measurement coils, the first measurement coil has a first electronic circuit that processes the sensor signal output from the first measurement coil before it is sent to the current measurement circuit. The processing may include at least one of: signal amplification; analog-to-digital conversion; voltage to current conversion.

The result is a signal that is more immune to the pickup of EM noise (for example, stray electromagnetic fields from a neighbouring, un-related conductor), which should improve the signal to noise ratio (SNR) and integrity of the signal received by the current measurement circuit, and therefore improve the accuracy of current measurement. This may be particularly effective when the first electronic circuit is located at a position that is close to the first measurement coil, so that minimal EM noise pickup occurs in the conductor between the measurement coil and the electronic circuit. There may also be a similar second electronic circuit for the second measurement coil. The outputs of the two electronic circuits can then be combined to effectively make a virtual larger coil for the measurement of the current in the conductor that the two coils together at least partially surround, with each coil contributing to the measurement of the current in the conductor. A virtual larger coil is created in that the two coils are not passively connected together to form a single conductive coil, the output of which is measured in order to measure the current in the current carrying conductor, as is the case with previous designs. Instead, the independent signal outputs of the active circuits are combined such that the combined signal essentially corresponds to a signal output by a larger coil formed by the two separate coils.

Amplification by the active circuits prior to transmission of the signals to where they will be combined (for example, at a measurement circuit) reduces the input referred noise of any subsequent EM pickup in the wires and connectors that carry the signals to where they will be combined. If there is a gain of 30, for example, in the active circuit, the same loop of interconnect will pick up the same EM noise as in the passively coupled designs, but the signal will be 30 times bigger so the relative SNR will be 30 times better. Analog to digital conversion by the active circuits prior to transmission of the signals to where they will be combined means that when the signals are transmitted, they are in a form that should be practically immune to EM pickup. Voltage to current conversion by the active circuits prior to transmission of the signals to where they will be combined (for example, at a measurement circuit), means that any subsequent EMF voltage picked up in the wires and connectors that carry the signals to where they will be combined should not, to a first order, influence the current signal being sent. These are just some examples of the active processing that may be performed to reduce the susceptibility the noise. There may be other means of active processing of the signals picked up by the coil that may reduce the sensitivity to pickup of noise in the conductors that carry the signals to where they are combined.

The signals from the actively processed signals from each of the coils may be combined at a number of different locations. For example, the actively processed signal from one coil may be carried through a conductor to the location of the active circuitry of the other coil, and combined there. Alternatively, actively processed signal from both of the coils may be carried by respective conductors to a third location, such as a processor that contains circuitry to receive and combine the signals, to a somewhere upstream of signal measurement circuitry that is configured to measure the combined signal.

Combining the signals may be through summation, with or without a weighting (i.e., with or without a different amount of gain being applied to the coil signals by their respective active circuits). For example, a weighting may be applied to at least partially correct for a difference in signal strength of each coil and/or processing path. Applying a weighting can allow the coils to be deliberately different (for example, different sizes) or can be used to correct for inconsistencies that would cause undesirable errors. For example, if the coils were meant to be matched but in fact were not, in the old technique of passively connecting the two to form a single coil, one part of the coil would be more sensitive than the other meaning that if the current carrying conductor position relative to each part of the coil changed, there would be a subsequent error in the measurement.

In the present disclosure, combining the actively processed signals from each coil may occur in either the analog or digital domain. Combining in the analog domain can be done through combining the actively processed signals through a passive circuitry, for example, using two resistors or through an amplifier such as an inverting amplifier with two input resistors and one feedback resistor.

Alternatively combining the signals may occur in an interconnect between the outputs of the two active circuits. For example, if the active circuitry for each coil has an amplifier with an output impedance or a voltage to current converter, connecting together the outputs of the active circuits should produce a summation of the two actively processed signal.

Actively processed signal from two or more coils may be combined (in either the analog or digital domain) in accordance with the present disclosure. The individual coils do not have to be identical and they may be of any suitable shape, for example partially circular (for example, an arc shape), rectilinear or any other shape when actively processed signal from the coils are combined, the resultant virtual, combined coil encompasses or encircles more of the current carrying conductor than each individual coils.

The place where the combination happens can be shared with measurements for more than one conductor. For example, there could be a processor that takes streams of signals from multiple coils for each conductor in a 3 phase system.

The signals output from each coil are a representation of the di/dt of the current in the current carrying conductor. To determine a measure of current, the signals may be integrated before or after they are combined. Optionally, other additional processing may be performed in the active circuits prior to signal combining, or in other circuits after signal combining, such as high pass filtering, low pass filtering, delay, offset or gain compensation, etc.

As a result of the designs in the present disclosure, not only may the measurement accuracy be improved by allowing independent weighting and correction to be applied to each measurement coil that contributes to the final current measurement, but the sensitivity to pickup of EM noise in the interconnect between the measurement coils may also be significantly improved. Consequently, the effect of imperfections/asymmetries in the effective combined coil may be reduced, and the integrity of the sensor signals output from the measurement coils may be improved by practically eliminating EM noise pickup that usually takes place in the inter-coil electronical connections. This should even further improve the accuracy of current measurement. Furthermore, by reducing or minimising discontinuities in the coil, the sensor's resilience to variations in the position and/or angle of the current carrying conductor as it passes through may be enhanced, as the reduction in discontinuities should result in the gain of the sensor remaining more consistent. Even further, reducing the requirements on inter-coil electrical connections may reduce manufacturing and installation complexity and costs.

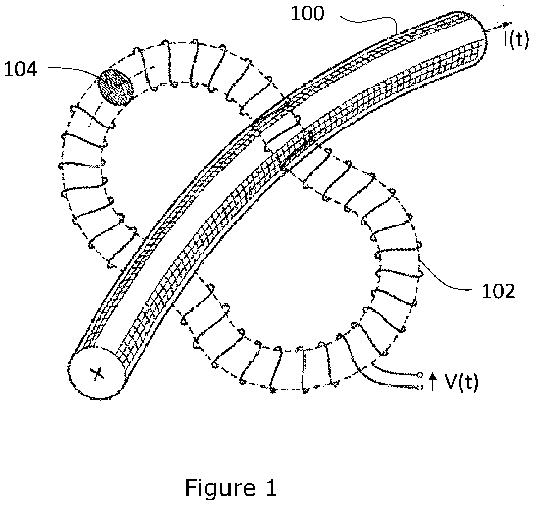

Figure 1 is a diagram of a known Rogowski coil, which is one example of a rate-of-change of field current sensors (sometimes referred to as dI/dt current sensors). So as to measure the current I(t) flowing through a current carrying conductor 100, a measurement coil 102 is arranged such that the current carrying conductor 100 passes through the measurement coil. The measurement coil 102 is wound as a helix, such that a loop or turn of the helix encloses a cross sectional area 104, A. The current carrying conductor 100 may be, for example, a bus-bar.

As the current I(t) in the current carrying conductor 100 changes, the field generated by the current also changes. The positioning of the measurement coil causes a voltage to be induced in the measurement coil 102 which is proportional to the rate of change of current, dI/dt. Therefore, integrating the output v(t) of the measurement coil provides a value proportional to the current. Each turn or loop of the coil forms a measurement area 104 in a plane perpendicular to the progression of the current carrying conductor.

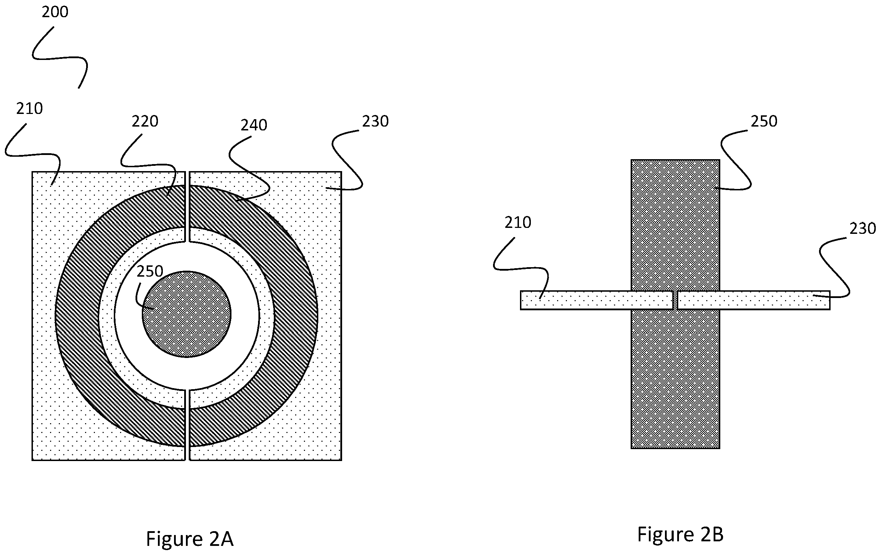

Figures 2A and 2B show a first example of a PCB implemented clamp-on current sensor 200. The current sensor 200 comprises a first PCB 210 on which is formed a first measurement coil 220 (for example, using conductive traces on two layers of the first PCB 210 - such as on the upper and lower surfaces of the PCB 210 - and conductive vias passing through the first PCB 210 between the upper and lower surfaces, as will be well understood by the skilled person). The current sensor 200 also comprises a second PCB 230 on which is formed a second measurement coil 240 (for example, using conductive traces on two layers of the second PCB 230 - such as on the upper and lower surfaces of the second PCB 230 - and conductive vias passing through the second PCB 230 between the upper and lower surfaces, as will be well understood by the skilled person). More PCB layers can be used to form the coil if available, or the layers used for the coils may be inside (eg, sandwiched between) other layers of the PCB.

Figure 2A shows the current sensor 200 from a direction that is perpendicular, or normal, to the surfaces of the first PCB 210 and second PCB 230 (eg, a top-down view). Figure 2B shows the current sensor 200 from a direction that is parallel to the surface of the first PCB 210 and the second PCB 230 (eg, a side-on view).

Figures 2A and 2B show the current sensor 200 in position, encircling a current carrying conductor 250, such as a conductive wire or busbar. The first PCB 210 and second PCB 230 may be configured to be positioned relative to each other and the current carry conductor 250 so as to encircle the current carry conductor, and then clamped in that position (for example, using clamp mechanisms on the first PCB 210 and second PCB 230 that engage with each to hold the first PCB 210 and second PCB 230 in the relative position represent in Figures 2A and 2B, or using some external clamp mechanism, such as a frame or housing).

In the example of Figure 2B, the first PCB 210 and second PCB 230 are configured to be positioned relative to each other such that the planes of the two PCBs substantially align.

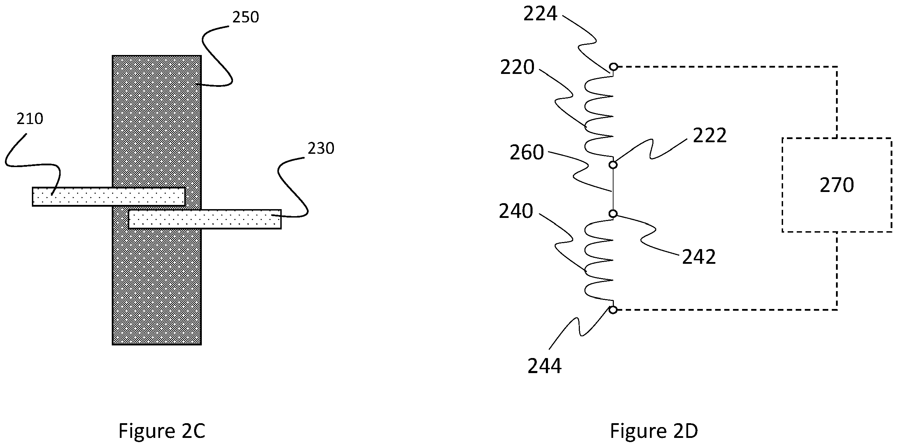

Figure 2C shows an alternative arrangement of the first PCB 210 and second PCB 220. Figure 2C shows the current sensor 200 from a direction that is parallel to the surface of the first PCB 210 and the second PCB 230 (eg, a side-on view). It is very similar to the arrangement of Figure 2B, except that the first PCB 210 and second PCB 220 are configured to be positioned relative to each other so as to encircle the current carrying conductor 250 and so as to partially overlap each other when viewed from a top-down direction. In the case of both Figure 2.

In the examples of Figures 2A to 2C, the first measurement coil 220 and the second measurement coil 240 are configured to be passively electrically connected to each other so as to electrically form a single, combined coil. For example, each measurement coil will have two ends - one at the start of the coil and one at the end. A first end of each coil can be passively electrically connected to the other, for example via a conductive wire or lead. In one particular example, they may be connected to each other using "pogo-pins". In this way, the two measurement coils may electrically form a single coil, for example a single Rogowski coil, that encircles or surrounds the current carrying conductor 250.

Figure 2D shows an example schematic electrical circuit diagram showing the connecting together of the first measurement coil 220 and second measurement coil 240. The first end 222 of the first measurement coil 220 is connected to the first end 242 of the second measurement coil 240 by a conductor, such as a pogo pin or wire. The second end 224 of the first measurement coil 220 and the second end 244 of the second measurement coil 240, may be connected to a current measurement circuit 270. The current measurement circuit 270 is a circuit configured to determine a measurement of the current in the current carrying conductor 250 based on an analog signal from the first measurement coil 220 (eg, the signal at the second end 224 of the first measurement coil 220) and an analog signal from the second measurement coil 240 (eg, the signal at the second end 244 of the second measurement coil 240). In one example the two analog signals may together form a differential signal and in another example, the second end of one of the measurement coils may be grounded or held at a reference voltage and other analog signal received from the other measurement coil may effectively be a single ended signal. The skilled person will readily appreciate the sorts of components and devices that may form part of the current measurement circuit 270, so that will not be described further herein.

The inventors have recognised that connecting the first measurement coil 220 and the second measurement coil 240 as described above has a number of drawbacks. In many cases, for example with pogo-pins, the passive connection between the two coils needs to be very precisely aligned in a specific position. For example, the two sides of the pogo pin need to be exactly positioned on the first PCB 210 and second PCB 230 so that when they are brought together, the first coil 220 and second coil 240 are in the correct relative position. If they are misaligned, this can create an imbalance in the signals output from the two coils which can affect the accuracy of current measurement. Furthermore, the pitch of coils making up the first and second measurement coils 220 and 240 is typically tighter than the conductive connector 260. For example, normally the minimum dimensions of the PCBs 210 and 230 are exploited to make the first and second coils 220 and 240 as high density as possible (for example, making the pitch between each coil making up the first and second coils 220 and 240 as small as possible). However, the conductive connector 260 does not normally match that pitch. As a result, the conductive connector 260 may introduce some asymmetries, non-idealities and/or irregularities in the coil that is formed by the first and second measurement coils 220 and 240. This may again affect the accuracy of current measurement.

In consideration particularly to pogo-pins, which are the most commonly used form of connection, they generally add height (eg, z-direction, perpendicular to the surface plane of the PCBs) and/or x and/or y displacement to the coil. Other connectors with male and female parts could be used but these tend to increase height and inconsistencies with the desired coil form. This increases the overall asymmetry in the coil structure and may also expose the coil to interference (for example, electromagnetic interface), which reduces current measurement accuracy in the presence of external unrelated magnetic fields, such as from current in a neighbouring conductor. Furthermore, pogo-pins (as well as other types of interconnectors) tend to increase the complexity of the overall manufacture and assembly of the device.

Furthermore, their positional accuracy can be difficult to control and be unpredictable, and they can be unreliable.

Furthermore, the connections between the second ends 224 and 244 of the first and second measurement coils 220 and 240 and the current measurement circuit 270 may be susceptible to interference. For example, owing to size (or other) constraints, the current measurement circuit 270 may need to be positioned relatively far from the first and second measurement coils 220 and 240, potentially on a third PCB (not represented in the drawings). This means that relatively long electrical connections are needed to connect the second ends 224 and 244 to the current measurement circuit 270. Such electrical connections are susceptible to picking up signal noise, for example from electro-magnetic (EM) interference. Since the signals from the first and second measurement coils 220 and 240 are typically very small (for example, in the order of less than 1 mV rms for a 100A RMS signal at 50Hz,), this interference can significantly diminish the signal-to-noise (SNR) ratio even if the dimension of the extra loops associated with the electrical interconnection is only a few mm's. Even in the case where the current measurement circuit 270 can be positioned on one of the first PCB 210 or second PCB 230, relatively close to the second end of the first measurement coil 220 or second measurement coil 240, there will still need to be a connection between the second end of the other measurement coil and the current measurement circuit 270, which may be susceptible to picking up signal noise.

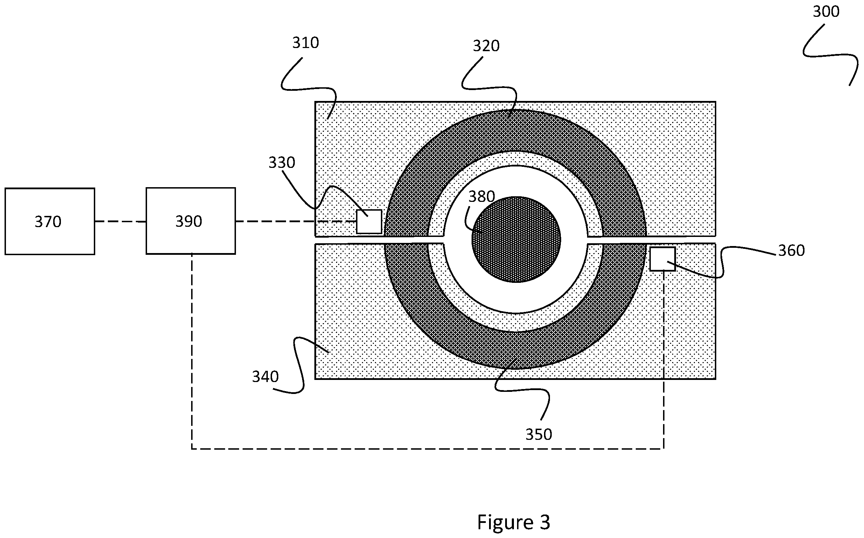

Figure 3 shows an example schematic diagram of a system 300 according to an aspect of the present disclosure, which the inventors have developed to address the above described shortcomings. The system comprises a first PCB 310 on which is formed a first measurement coil 320, and a second PCB 340 on which is formed a second measurement coil 350. As with the examples described with reference to Figures 2A to 2D, the first measurement coil 320 and the second measurement coil 350 are configured for positioning relative to each other and a current carrying conductor 380 so as to at least partially surround (or encircle) the current carrying conductor. The system 300 may be configured so that when in place around the conductor 380, the first and second PCBs 310 and 340 substantially align, similarly to Figure 2B, or such that the first and second PCBs 310 and 340 partially overlap each other when viewed from a top-down direction, similarly to Figure 2C.

The system 300 further comprises a first electronic circuit 330 comprising a first input coupled to the first measurement coil 320 and a first output for coupling to a measurement circuit 370 (in this example via a combining circuit 390, as explained later). For example, a first end of the first measurement coil 320 may be coupled to the first electronic circuit 330 and a second end of the first measurement coil 320 may be coupled to a reference voltage, such as ground. In this case, the first electronic circuit 330 receives from the first measurement coil 320 a first sensor signal that is a single ended signal. In an alternative, both the first and second ends of the first measurement coil 320 may be coupled to the first electronic circuit 330, for example where the first measurement coil 320 comprises a plurality of coils or loops and a return wire that passes through the centre of the coil from one end of the coil to the other, such that the first and second ends of the first measurement coil 320 terminate close to each other (which is a well known feature of Rogowski coils, for example). In this case, the first electronic circuit 330 receives from the first measurement coil 320 a first sensor signal that is a differential signal. Thus, it can be seen that the first electronic circuit 330 can be positioned very close to the end(s) of the first measurement coil 320 to which it is coupled. This should keep to a minimum any signal interference that may be picked up by the conductor that couples the end(s) of the first measurement coil 320 to the first measurement circuit 330. As a result, even though the signal received by the first electronic circuit 330 is likely to be relatively small (for example, less than 1 mV rms for a 100A RMS signal at 50Hz), it should still have good SNR since noise pick-up from interference should be very small, or zero.

The system 300 also comprises a second electronic circuit 360 comprising a second input coupled to the second measurement coil 350 and a second output for coupling to the measurement circuit 370 (in this example via a combining circuit 390, as explained later). For example, a first end of the second measurement coil 350 may be coupled to the second electronic circuit 360 and a second end of the second measurement coil 350 may be coupled to a reference voltage, such as ground. In this case, the second electronic circuit 360 receives from the second measurement coil 350 a second sensor signal that is a single ended signal. In an alternative, both the first and second ends of the second measurement coil 350 may be coupled to the second electronic circuit 360, for example where the second measurement coil 350 comprises a plurality of coils or loops and a return wire that passes through the centre of the coil from one end of the coil to the other, such that the first and second ends of the second measurement coil 350 terminate close to each other (which is a well-known feature of Rogowski coils, for example). In this case, the second electronic circuit 360 receives from the second measurement coil 350 a second sensor signal that is a differential signal. Thus, it can be seen that the second electronic circuit 330 can be positioned very close to the end(s) of the second measurement coil 350 to which it is coupled. This should keep to a minimum any signal interference that may be picked up by the conductor that couples the end(s) of the second measurement coil 350 to the second measurement circuit 360. As a result, even though the signal received by the second electronic circuit 360 is likely to be relatively small (for example, less than 1 mV rms for a 100A RMS signal at 50Hz), it should still have good SNR since noise pick-up from interference should be very small, or zero.

The first electronic circuit 330 and the second electronic circuit 360 may each comprise any one or more of the following circuits/devices: one or more amplifiers; an analog to digital converter (ADC); a voltage-to-current (V-2-I) converter. The first electronic circuit 330 and the second electronic circuit 360 may be referred to as "active" circuits in that they comprise one or more powered devices/circuits, as opposed to a circuit that consists of only passive components/devices, such as conductive wires/traces, resistors and capacitors.

In one example, the first electronic circuit 330 and the second electronic circuit 360 may each comprise one or more amplifiers configured to generate an amplified version of the first sensor signal received from the first measurement coil 320 and the second sensor signal received from the second measurement coil 350. Any suitable type of amplifier circuit may be used. In this case, the first electronic circuit 330 generates and outputs a first actively processed signal that is an amplified version of the first sensor signal, and the second electronic circuit 360 generates and outputs a second actively processed signal that is an amplified version of the second sensor signal. The combining circuit 390 and/or current measurement circuit 370 may be positioned close to one of the first electronic circuit 330 or the second electronic circuit 360 (for example, mounted on the first PCB 310 or second PCB 370), or may be positioned relatively far away, for example on a third PCB. Regardless, noise is likely to be picked up in the electrical connections between the first electronic circuit 330 and the combining circuit 390 and/or current measurement circuit 370, and between the second electronic circuit 360 and the combining circuit 390 and/or current measurement circuit 370. However, because the actively processed signals transmitted from the first and second electronic circuits 330 and 360 are amplified versions of the first and second sensor signals, this should improve the integrity and SNR of the signals received at the measurement circuit 370 compared with the examples given above with reference to Figures 2A and 2D. This is because for the same extra loop of the interconnect, the signal is at an amplified level, so the pickup levels have been reduced relative to the amplification signal level. Consequently, regardless of where the combining circuit 390 and/or current measurement circuit 370 are positioned, and regardless of the conductive routing between the different circuits, better integrity and SNR should be achieved, which should improve the accuracy of measurement performed by the measurement circuit 370. The combining circuit 390 and current measurement circuit 370 may be implemented separately, for example in separate packages or ICs that may be mounted on the same or different PCBs, or may be implemented together, for example in the same package or IC. Alternatively, circuits may be combined in the same IC, for example one coil being locally coupled to a first IC that includes an active processing circuit (for example, an amplification circuit) and also the combining circuit 390, and the other coil being locally coupled to a second IC that includes just an active processing circuit (for example, an amplification circuit) which then send its signal to the first IC through an interconnect.

In another example, the first electronic circuit 330 may comprise a first ADC to generate a first digital conversion of the first sensor signal, and the second electronic circuit 360 may comprise a second ADC to generate a second digital conversion of the second sensor signal. In an alternative, the first and second electronic circuits 330 and 360 may also each comprise an amplifier configured to amplify the first and second sensor signal respectively, with the first and second ADCs configured to convert the amplified versions of the first and second sensor signals respectively. In either case, the first and second ADCs are configured to generate and output first and second digital signals that are dependent on the first and second sensor signals. Any suitable type of ADC may be used, for example SAR, flash, sigma-delta, etc.

By communicating the first and second actively processed signals as digital signals, the signals should be substantially or completely immune to EM noise pickup (for example, provided the level of EM interference is not so large as to corrupt the logic levels used to transmit the digital signals). Consequently, regardless of where the combining circuit 390 and/or measurement circuit 370 is positioned, and regardless of the conductive routing between the circuits, a good SNR should still be preserved.

In another example, the first electronic circuit 330 may comprise a first V-2-I converter to generate a first current that is dependent on the voltage of the first sensor signal, and the second electronic circuit 360 may comprise a second V-2-I converter to generate a second current that is dependent on the voltage of the second sensor signal. Optionally the first and second electronic circuits 330 and 360 may comprise an amplifier to amplify the first and second sensor signals before they are converted by the first and second V-2-I converters. Current signals have higher immunity to magnetic noise pickup compared with voltage signals as the EM effect on the extra interconnect loop is to create a voltage, which only modifies the current slightly due to the output impedance of the current source of the V-2-I converter, so by converting the signals to that form before they are output from the first and second electronic circuits 330 and 360 should improve EM noise immunity. Consequently, regardless of where the combining circuit 390 and/or current measurement circuit 370 is positioned, and regardless of the conductive routing between the circuits, a good SNR should still be preserved.

In all of these examples, the term "actively processed signal" is intended to mean a signal that has been generated by some form of active electronic circuitry (including, but not limited to, amplification and/or digital conversion and/or V-2-I conversion) acting on the sensor signals output by the measurement coils. It should be noted that more than one type active processing may occur, for example there may be amplification before an ADC or a V-2-I converter. In addition, the electronic circuits may optionally perform one or more additional signal processing functions, either passively or actively, such as signal filtering (high and/or low pass), integration, signal delay, signal offset, gain compensation, etc.

If the combined signal is an analog signal, the measurement circuit 370 may either measure the electrical measurand in the analog domain, or may digitally convert the combined signal and measure the electrical measurand in the digital domain.

In conclusion, it can be seen that in all of the examples of the first and second electronic circuits 330 and 360, significantly greater measurement circuit 370 positioning flexibility is achieved whilst also improving (or at least not sacrificing) SNR for the signals received at the measurement circuit 370. Furthermore, no electrical coupling between the first and second measurement coils 320 and 350 is required and instead signals based on the outputs of the coils are combined elsewhere, by the combining circuit 390, which may further reduce signal interference, improve coil symmetry and regularity, and means that components such as pogo-pins are not required. Consequently, improved flexibility for positioning of the current measurement circuit 370 may be achieved, which may simplify manufacture and/or installation of the system 300, whilst maintaining or improving the accuracy of current measurement as a result of the good SNR and good measurement coil symmetry. Furthermore, by reducing or minimising discontinuities in the coil, the sensor's resilience to variations in the position and/or angle of the current carrying conductor as it passes through may be enhanced, as the reduction in discontinuities should result in the gain of the sensor remaining more consistent.

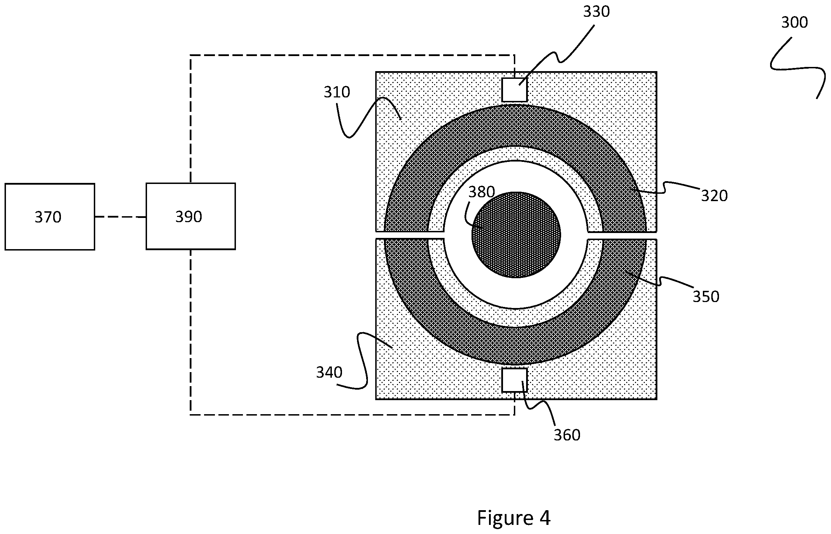

Figure 4 shows a schematic diagram of an alternative implementation of the system 300, where the position of the first and second electronic circuits 330 and 360 relative to the first and second measurement coils 320 and 350 is different. The first and second electronic circuits 330 and 360 may be positioned anywhere on the first and second PCBs 310 and 340, usually in dependence on the particular design of the first and second measurement coils 320 and 350, for example so as to be close to an end (or the end) of the measurement coil to which the electronic circuit is coupled. In this example, the coils 320 and 350 may be differential in nature, carrying a balanced pos (positive) coil anticlockwise from the electronic circuit and a neg (negative) coil clockwise from it to create a differential pick up. One potential advantage of this arrangement is that the electronic circuits can be positioned away from each board edge and so may allow the boards to abut each other in a closer, more symmetric way for the virtual coil.

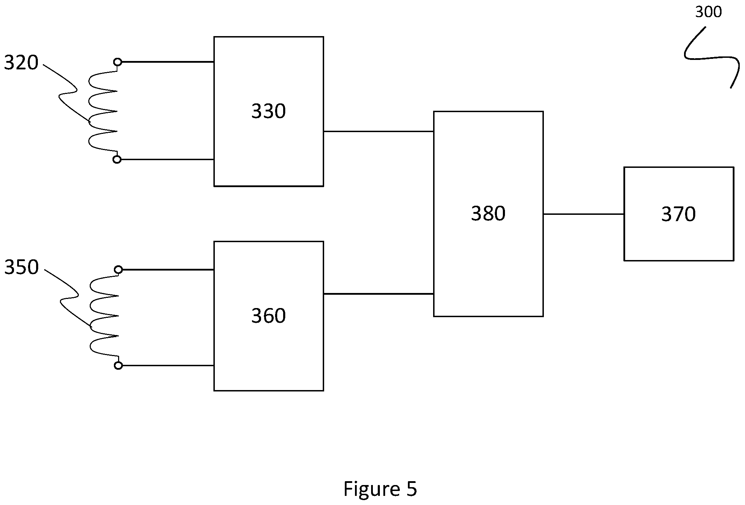

Figure 5 shows a schematic circuit diagram for the system 300. In this example, both ends of the first measurement coil 320 are coupled to the first electronic circuit 330 and both ends of the second measurement coil 350 are coupled to the second electronic circuit 360. The measurement coil may be made of multiple pieces (for example, using return wires, as is well known in Rogowski Coils). There may be a bias voltage or a ground connection in the middle of each coil so that the signals received at the first and second electronic circuits 330 and 360 are differential with respect to the bias voltage or ground. As a result, the first and second electronic circuits 330 and 360 receive the first and second sensor signals as differential signals. In an alternative, the system 300 may be configured so that the first and second sensor signals are single ended, as explained earlier. Furthermore, whilst the outputs of the first and second electronic circuit are represented as being single ended, they may alternatively be differential. Furthermore, whilst the output of the combining circuit 390 is represented as being single ended, it may alternatively be differential.

The combining circuit 390 is arranged to couple the output of the first electronic circuit 330 to the measurement circuit 370 and couple the output of the second electronic circuit 360 to the measurement circuit 370 by generating a combined signal by combining the first and second actively processed signals and outputting the combined signal to the measurement circuit 370. The combined signal may, for example, be the sum or average of the first and second actively processed signals, and the combining circuit 390 may comprise any suitable passive and/or active circuitry configured for this purpose.

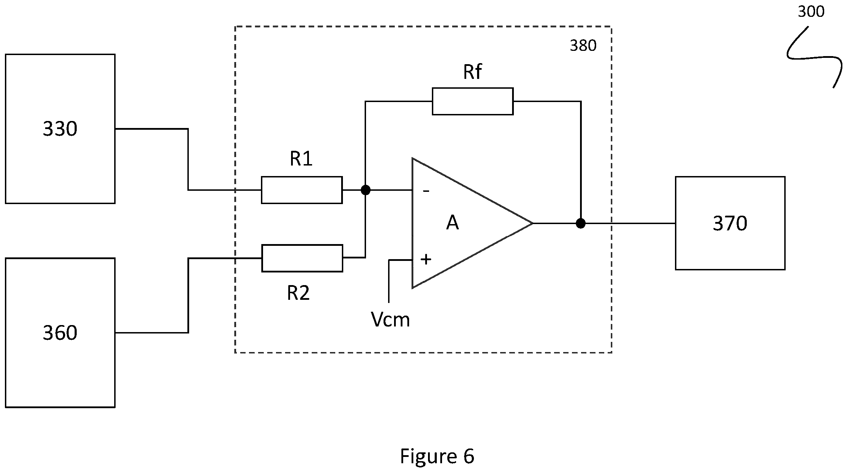

Figure 6 shows on example implementation of the combining circuit 390, which comprises an inverting amplifier formed by the op amp A and resistors R1, R2 and Rf. As a result, the combined signal output by the combining circuit 390 is a weighted average of the analog first actively processed signal and the analog second actively processed signal, with the weighting being determined by the relative size of R1 and R2. It will be appreciated that any other suitable amplifier circuit may be used, for example inverting or non-inverting, or using one or more transistors suitably biased with resistors, etc. In this example, the combining circuit 390 is an active circuit.

In this example, Vcm is the common mode voltage of the first and second coils 320, 350, for example where one end (such as the return wire end) of each of the coils is coupled to a reference voltage or ground, such that the analog signals output by the first and second coils 320, 350 are differential relative to Vcm. In this example, the gain applied to the first actively processed signal is determined by the relative size of R1 and Rf and the gain applied to the second actively processed signal is determined by the relative size of R2 and Rf. The output of the amplified is a weighted average of the two actively processed signals, where the weighting is determined by the relative gains applied to each signal.

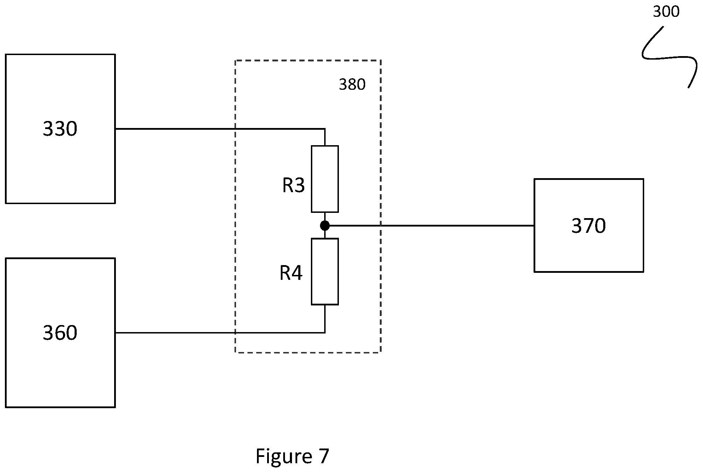

Figure 7 show a further example implementation of the combining circuit 390, which comprises two resistors R3 and R4 formed as a potential divider. If R3 and R4 are matched (i.e., have the same resistance), the combined signal is the average of the analog first actively processed signal and the analog second actively processed signal. Alternatively, R3 and R4 may not be matched but may instead have different resistances such that the combined signal is effectively a weighted average of the first actively processed signal and the second actively processed signal. This may, for example, to be to correct for imbalances that are inherent in the relative designs of the first and second coils 320 and 350 (for example, where one coil is larger than the other), or to correct for imbalances caused by imperfections in the manufactured coils 320, 350 and/or electronic circuits 330, 360. For this purpose, one or both of the resistors may be variable such that the weighting may be adjusted during system calibration. In this example, the combining circuit 390 is a passive circuit.

In an alternative, if the first and second electronic circuits 330, 360 have a high output impedance (for example, if they have V-2-I converters or high output impedance amplifiers), the combining circuit 390 may simply connect together the outputs of the first and second electronic circuits 330, 360 to produce a combined signal that is the sum of the first and second actively processed circuits.

In a further alternative, if the first and second actively processed signals are both analog, the combining circuit 390 may comprise one or more analog to digital circuits, ADCs, (for example, one that is shared between the first and second actively processed signals using a multiplexer, or one for each of the first and second actively processed signals) and digital circuitry to combine the two digital signals, for example by averaging or summing them. Alternatively, if the first and second actively processed signals received by the combining circuit 390 are digital signals, the combining circuit 390 may simply comprise digital circuitry to combine the two digital signals, for example by averaging or summing them. In both cases, the combined signal is a digital signal and the combining circuit 390 is an active circuit.

The measurement circuit 370 may be configured to measure any one or more electrical measurands that are dependent on the current in the current carrying conductor 380. For example, it may be configured to measure any one or more of:
- the rate of change of current in the current carrying conductor 380 using the received combined signal;
- the magnitude (and optionally also polarity) of current in the current carrying conductor 380 by integrating the received combined signal;
- electrical energy associated with the current in the current carrying conductor 380, for example by determining the magnitude of current in the current carrying conductor 380 and multiplying it with a measurement of voltage;
- electrical power associated with the current in the current carrying conductor 380, for example by determining the energy per unit time.

As such, it can be seen that the system 300 of the present disclosure may be used as part of a utility meter configured to measure electrical energy consumption for billing purposes.

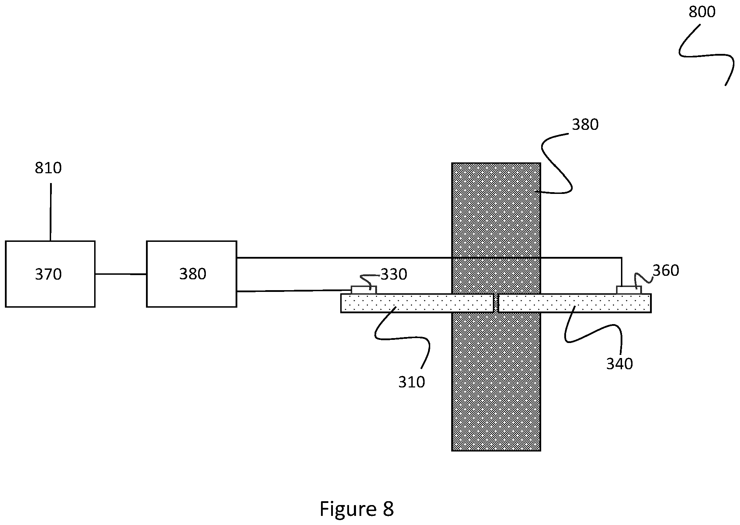

Figure 8 shows an example implementation of a utility meter 800. The current carrying conductor 380 is not part of the utility meter 800, but is the conductor carrying the current that is to be measured by the utility meter 800. For example, it may be the "live" conductor feeding a domestic or industrial building. The measurement circuit 370 is configured also to receive a voltage signal 810 indicative of a voltage associated with the current in the conductor 380 such that the energy and/or power supplied by the current in conductor 380 can be measured by the measurement circuit 810. In this example the utility meter 800 measures the current in only one conductor, although it will be appreciated that it may be configured to measure it in more than one conductor, for example in the live and neutral conductors supplying power to a domestic or industrial building, or in each phase conductor of a multiphase power supply (in which case the signals for each phase may be combined in the same location to generate a combined signal for each phase, or the combined signal for each phase may be generated by separate combining circuits in separate locations) . In such examples, first and second measurement coils may be fitted to each conductor to be measured, and each pair of measurement coils may have an associated combining circuit 390. In this way, the measurement circuit 370 may receive combined signals from each pair of measurement coils, such that the current in each conductor may be measured.

Additional or alternative uses of measurements of the electrical measurand include, for example, any one or more of motor control, condition based monitoring, fault detection, etc. As such, the measurement circuit 370 may form part of a wider system, or other systems may use measurements output by the measurement circuit 370.

The skilled person will readily appreciate that various alterations or modifications may be made to the above described aspects of the disclosure without departing from the scope of the disclosure.

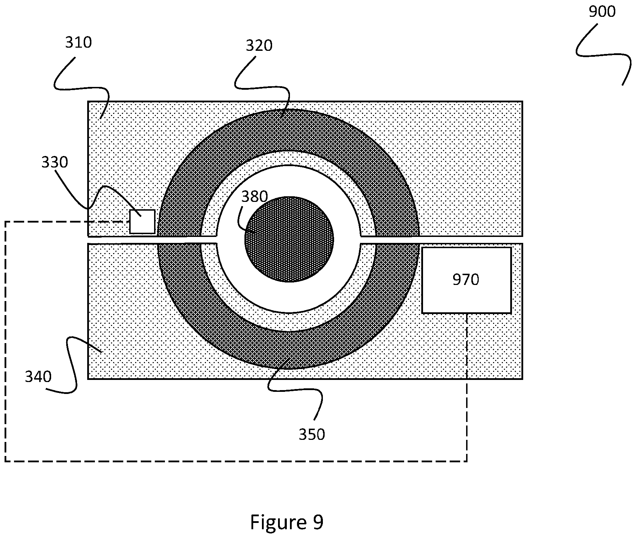

Figure 9 shows an example schematic diagram of a system 900 according to one alternative implementation. This example is very similar to those of Figures 3 and 4, but does not include a dedicated second electronic circuit 360. Instead, the second measurement coil 350 is coupled to the measurement circuit 970, ideally as close as possible to the coil end(s) of the second measurement coil 350. In this example, the measurement circuit 970 is mounted on the second PCB 340 and effectively comprises the second electronic circuit 360, the combining circuit 390 and the measurement circuit 370. It comprises a circuit equivalent to the second electronic circuit 360 so that the first and second sensor signals may be processed in equivalent ways (for example, conversion to digital signals or current signals) before being combined. As explained above, the electrical coupling of the first electronic circuit 330 to the measurement circuit 970 should be largely, or entirely, immune to noise pick-up, and by positioning the measurement circuit 970 close to the second measurement coil 350, the SNR of the second sensor signal should also be good. Furthermore, just as explained above, no electrical coupling between the first and second measurement coils 320 and 350 is required, which may further reduce signal interference, improve coil symmetry and regularity, and means that components such as pogo-pins are not required. Consequently, accuracy of the measurement of the electrical measurand should be improved as a result of the good SNR and good measurement coil symmetry, whilst also reducing complexity and cost by not requiring an electrical connection between the first and second measurement coils 320 and 350. Furthermore, by reducing or minimising discontinuities in the coil, the sensor's resilience to variations in the position and/or angle of the current carrying conductor as it passes through may be enhanced, as the reduction in discontinuities should result in the gain of the sensor remaining more consistent.

In each of the examples above, signals from each of the measurement coils 320 and 350 are combined. As a result, the combined signal effectively represents a signal from a virtual coil that corresponds to the combination of the two measurement coils 320 and 360, when in fact two, electrically separate measurement coils each partially surround the current carrying conductor 380. As explained earlier, an electrical connection between the two measurement coils 320 and 350 is therefore not required, which may reduce cost and complexity of manufacture and installation, as well as improve the accuracy of current measurement.

Furthermore, it enables a different weighting to be applied to the measurement signals corresponding to each measurement coil, which may have a number of benefits. In one example it may be used to correct for imperfections in the first and second measurement coils 320 and 350. For example, the manufactured thickness of the first and second PCBs 310 and 340 may be slightly different, which would mean that the coil sizes of the first and second measurement coils 320 and 350 will be different causing the coils to have different levels of induced signal. This may be detected during device calibration and may be corrected for by changing the relative weighting of the two signals that are combined by the current measurement circuit 370, 970 in order to measure the current (for example, changed to 49:51, or 52:48, etc). The relative weighting may be adjustable by any one or more of: adjusting the relative amplifier gains of the first and second electronic circuits 330, 360; adjusting the digital conversion performed by the first and second electronic circuits 330, 360 (for example, by changing the converter reference value or by applying a multiplication after conversion); and/or by adjusting the V-2-I conversion performed by the first and second electronic circuits 330, 360 (for example, by changing the current reference value) and/or adjusting at the combining circuit 390the relative weighting of the actively processed signals, either digitally or in analog, prior to combining.

A further benefit of the flexibility afforded by electrically combining signals in this way is that the size of the first and second measurement coils 320, 350 may be made to be deliberately different. The first measurement coil 320 is designed to subtend or encompass a first perimeter, or circumferential, portion (or a first arc) of the current carrying conductor 380, and the second measurement coil 350 is designed to subtend or encompass a second perimeter, or circumferential, portion (or a second arc) of the current carrying conductor 380. In the examples given above, the first and second perimeter portions are equal in size (for example, each subtending an angle of 180 degrees). However, in an alternative, the first and second circumferential portions may be different in size.

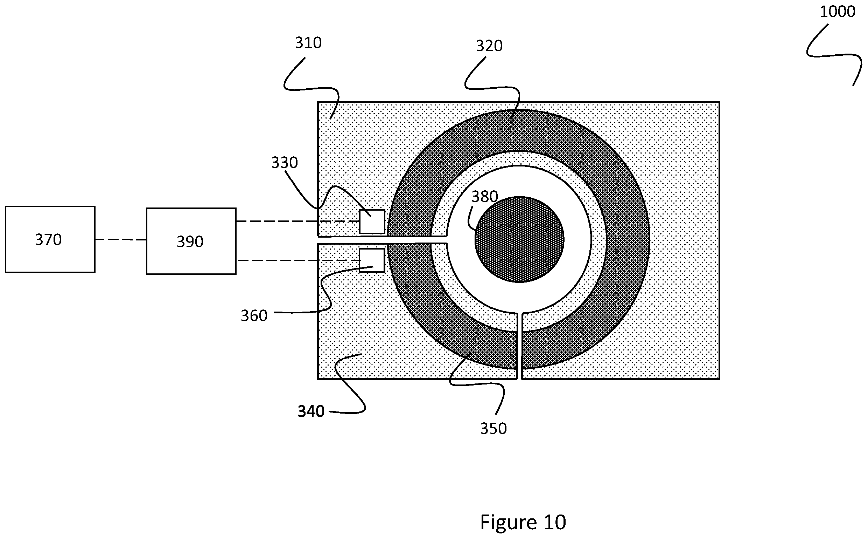

Figure 10 shows an example schematic diagram of a system 1000 according to an aspect of the present disclosure where the first and second perimeter portions are a different size. In this example, each of the first and second measurement coils 320 and 350 partially surround the current carrying conductor 380. However, the first measurement coil 320 partially surrounds more of the current carrying conductor 380 than the second measurement coil 350. In other words, the first perimeter, or circumferential, portion (or first arc) of the current carrying conductor 380 that the first measurement coil 320 skirts is larger than the second perimeter, or circumferential, portion (or second arc) of the current carrying conductor 380 that the second measurement coil 350 partially surrounds. Put another way, the angle subtended by the first measurement coil 320 is greater than that of the second measurement coil 350. The sensor signals output by the first and second measurement coils 320 and 350 may then be appropriately weighted (for example 75:25) by the first and second electronic circuits 330 and 360 and/or the combining circuit 390. This enables greater flexibility of measurement coil design, for example to allow for the creation of designs that will fit into particular spaces so that a measurement coil may be fitted around a current carrying conductor 370 that owing to physical space limitations could not previously have a measurement coil fitted.

For example, in each of the examples above, the current measurement systems are all configured such that when the first and second measurement coils 320 and 350 are put in place relative to the current carrying conductor 380, they together completely surround or encircle the current carrying conductor 380 (i.e., 360 degrees around the current carrying conductor). In the case of non-overlapping PCBs (such as that shown in Figure 2B), the two measurement coils may together subtend 360 degrees. In the case of overlapping PCBs (such as that shown in Figure 2C), two measurement coils may together subtend more than 360 degrees. However, in an alternative, they may together only partially surround the current carrying conductor 380, for example together subtending less than 360 degrees. For example, they may together subtend 300 degrees, or 350 degrees, etc.

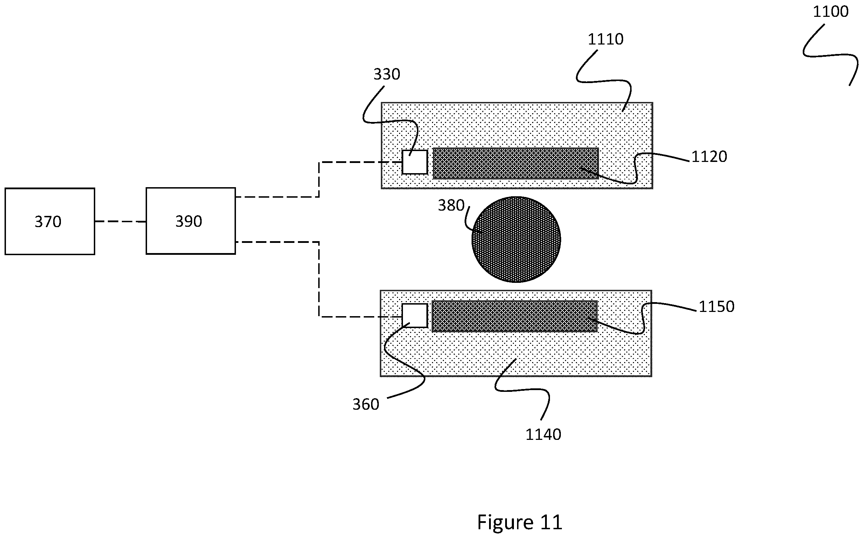

Figure 11 shows an example system 1100 in accordance with an aspect of the present disclosure, where two measurement coils each configured for partially surrounding the conductor 380 and together partially, but not fully, surround the conductor 380. Furthermore, in this example, each coil is not toroidal in shape, but is instead oriented in a linear fashion. The system 1100 comprises a first coil 1120 formed on a first PCB 1110 and a second coil 1150 formed on a second PCB 1140.

In each of the examples above, the first and second measurement coils are configured to be positioned such that they each subtend, or partially surround, respective perimeter portions of the current carrying conductor, and together subtend a combined perimeter portion of the current carrying conductor 380 that is greater than that subtended by each measurement coil on its own. This is regardless of whether the perimeter portion subtended by each measurement coil is the same or different, and regardless of whether the combined perimeter portion fully or only partially surrounds the current carrying conductor 380.

Additionally or alternatively, the current measurement system may comprise more than two measurement coils. For example, it may comprise three or more measurement coils, each implemented on their own PCB, and configured for positioning relative to each other and the current carrying conductor 380 so as to at least partially surround the current carrying conductor 380. In this case, each of the measurement coils may have a corresponding electronic circuit as described above.

In each of the examples given above, there is a single current sensor coil made up of two or more separate measurement coils 320 and 350. In an alternative, the current measurement system may comprise two or more current sensor coils, each made up of two or more separate measurement coils 320 and 350 implemented on respective PCBs. Each of the measurement coils may have a corresponding electronic circuit (or all but one of the measurement coils may have a corresponding electronic circuit) as described above, using the outputs of which the measurement circuit 370, 570 may determine a measurement of the measurand. Such examples may be where there is one current measurement coil that advances around the current carrying conductor 380 with clockwise helical turns, and other current measurement coil that advances around the current carrying conductor 380 with counter-clockwise helical turns.

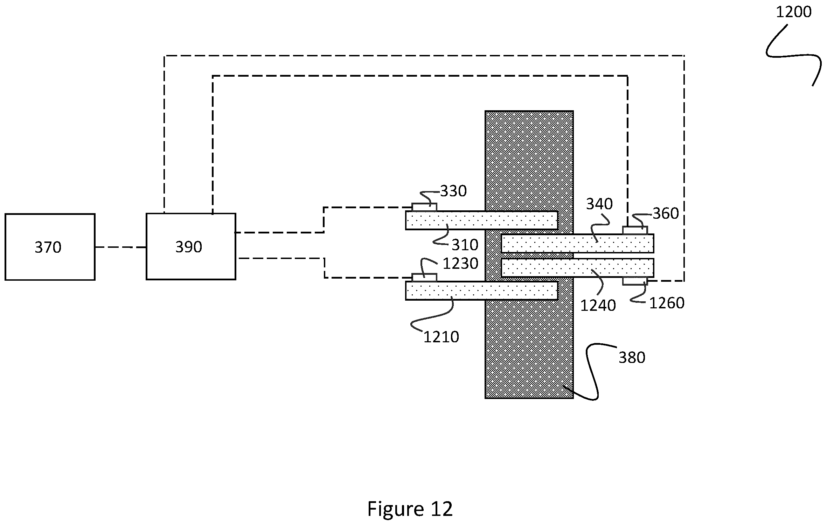

For example, Figure 12 shows an implementation of a system 1200 in accordance with an aspect of the present disclosure. In this example, there are four measurement coils arranged around the current carrying conductor 380 - the first measurement coil on the first PCB 310, the second measurement coil on the second PCB 340, a third measurement coil on a third PCB 1240 (which is essentially a duplication of the second measurement coil, but with the turns of the coil turning in the opposite direction) and a fourth measurement coil on a fourth PCB 1210 (which is essentially a duplication of the first measurement coil, but with the turns of the coil turning in the opposite direction). A third electronic circuit 1260 is essentially a duplication of the second electronic circuit 360 and a fourth electronic circuit 1230 is essentially a duplication of the first electronic circuit 330. The combining circuit 390 combines actively processed signals from all four electronic circuits to generate the combined signal, or combines the first and second actively processed signals to generate a first combined signal and combines the third and fourth actively processed signals (output by the third and fourth electronic circuits 1260 and 1230) to generate a second combined signal. In the latter case, the first and second combined signals may then be used by the measurement circuit 370 for measuring the electrical measurand.

In each of the examples given above, the measurement coils are implemented on PCBs. However, the principles of this disclosure may be applied to current measurement coils that are implemented in any other way.

Furthermore, in most of the examples given above, the combining circuit 390 and the measurement circuit 370 are separate circuits. However, they may be implemented within the same package or IC, in which case they could be seen as a single circuit. Furthermore, in some cases the functionality of combining the first and second actively processed signals may be performed by the measurement circuit 370, for example where the first and second actively processed signals are digital signals and the measurement circuit 370 combines them as part of its measurement functionality.

In the examples above, the measurement coils are within a PCB substrate. Alternatively they may be formed on or in other types of substrates, or using other types of winding. For example, the windings could be formed in a way in which they are flexible, or could be implemented using a different substrate material, or could be made by winding wire around a mechanical structure.

The terminology "coupled" used above encompasses both a direct electrical connection between two components, and an indirect electrical connection where the two components are electrically connected to each other via one or more intermediate components.

### Aspects

Non-limiting aspects of the disclosure are set out in the following numbered clauses.
1. A current sensor system for use in measuring an electrical measurand that is dependent on current in a current carrying conductor, the current sensor system comprising:
   a first measurement coil;
   a second measurement coil, wherein the first measurement coil and the second measurement coil are configured for positioning relative to each other and the current carrying conductor so as to at least partially surround the current carrying conductor;
   a first electronic circuit comprising a first input coupled to the first measurement coil and a first output for coupling to a measurement circuit, the first electronic circuit being configured to generate a first actively processed signal based on a first sensor signal received from the first measurement coil and output the first actively processed signal from the first output; and
   a second electronic circuit comprising a second input coupled to the second measurement coil and a first output for coupling to the measurement circuit, the first electronic circuit being configured to generate a second actively processed signal based on a second sensor signal received from the second measurement coil and output the second actively processed signal from the second output,
   wherein the first actively processed signal and the second actively processed signal are for combining to measure the electrical measurand that is dependent on current in a current carrying conductor.
2. The current sensor system of clause 1, wherein the first electronic circuit comprises a first amplifier configured to generate an amplified version of the first sensor signal, and
   wherein the second electronic circuit comprises a second amplifier configured to generate an amplified version of the second sensor signal.
3. The current sensor system of clause 2, wherein a gain of the first amplifier is the same as a gain of the second amplifier.
4. The current sensor system of clause 2, wherein a gain of the first amplifier is different to a gain of the second amplifier.
5. The current sensor system of any preceding clause, wherein the first electronic circuit comprises a first analog to digital converter, ADC, arranged to generate a first digital signal that is dependent the first sensor signal, and.
   wherein the second electronic circuit comprises a second analog to digital converter, ADC, arranged to generate a second digital signal that is dependent the second sensor signal.
6. The current sensor system of any preceding clause, wherein the first electronic circuit comprises a first voltage-to-current converter, wherein the first sensor signal is a voltage signal and the first voltage-to-current converter is configured to generate a first current signal that is dependent on the first sensor signal, and
   wherein the second electronic circuit comprises a second voltage-to-current converter, wherein the second sensor signal is a voltage signal and the second voltage-to-current converter is configured to generate a second current signal that is dependent on the second sensor signal.
7. The current sensor system of any preceding clause, further comprising:
   a combining circuit for coupling the first output of the first electronic circuit to the measurement circuit and coupling the second output of the second electronic circuit to the measurement circuit,
   wherein the combining circuit is configured to generate a combined signal for outputting to the measurement circuit by combining the first actively processed signal and the second actively processed signal.
8. The current sensor system of clause 7, wherein the combining circuit is a passive circuit configured to passively combine the first actively processed signal and the second actively processed signal.
9. The current sensor system of clause 7, wherein the combining circuit is an active circuit configured to actively combine the first actively processed signal and the second actively processed signal.
10. The current sensor system of clause 9, wherein the combing circuit comprises an amplifier comprising:
   inputs to receive the first actively processed signal and the second actively processed signal; and
   an output to output the first combined signal.
11. The current sensor system of clause 7, wherein the combining circuit comprises a digital circuit for digitally combining the first actively processed signal and the second actively processed signal.
12. The current sensor system of any preceding clause, wherein the first measurement coil is formed on a first printed circuit board, PCB, and
   wherein the second measurement coil is formed on a second PCB.
13. The current sensor system of clause 12, wherein the first electronic circuit is on the first PCB and the second electronic circuit is on the second PCB.
14. The current sensor system of clause 12 or clause 13, wherein the first PCB comprises a first clamp mechanism and the second PCB comprises a second clamp mechanism,
   wherein the first clamp mechanism and the second clamp mechanism are for engaging with each other so as to hold the first measurement coil and the second measurement coil in position such that they together surround at least part of the current carry carrying conductor when in use.
15. The current sensor system of any preceding clause, further comprising:
   the measurement circuit coupled to the first electronic circuit and the second electronic circuit and configured to measure the electrical measurand that is dependent on current in the current carrying conductor based on a combination of the first actively processed signal and the second actively processed signal.
16. The current sensor system of any preceding clause, wherein the electrical measurand that is dependent on current in the current carrying conductor comprises any one or more of:
   a rate of change of the current in the current carrying conductor;
   an amplitude of the current in the current carrying conductor;
   electrical energy associated with the current in the current carrying conductor;
   electrical power associated with the current in the current carrying conductor.
17. The current sensor system of any preceding clause, wherein the first measurement coil is for subtending a first perimeter portion of the current carrying conductor; and
   the second measurement coil is for subtending a second perimeter portion of the current carrying conductor.
18. The current sensor system of clause 17, wherein the first measurement coil and the second measurement coil are configured such that when they are in use, positioned relative to the current carrying conductor, they together subtend a combined perimeter portion of the current carrying conductor that is greater than each of the first perimeter portion and the second perimeter portion.
19. The current sensor system of clause 17 or clause 18, wherein the first perimeter portion is equal in size to the second perimeter portion, or the first perimeter portion is different in size to the second perimeter portion.
20. A measurement system for measuring an electrical measurand that is dependent on current in a current carrying conductor, the measurement system comprising:
   a combining circuit for coupling to a first measurement coil and a second measurement coil that are arranged to at least partially surround the current carrying conductor, wherein the combining circuit is configured to generate a combined signal by combining:
      a first actively processed signal that is dependent on a first sensor signal output by the first measurement coil; and
      a second actively processed signal that is dependent on a second sensor signal output by the second measurement coil; and
   a measurement circuit coupled to the combining circuit, wherein the measurement circuit is configured to measure the electrical measurand based on the combined signal.
21. A utility meter for measuring electrical energy supplied by a current carrying conductor, the utility meter comprising:
   a first measurement coil;
   a second measurement coil, wherein the first measurement coil and the second measurement coil are configured for positioning relative to each other and the current carrying conductor so as to at least partially surround the current carrying conductor;
   a measurement circuit;
   a first electronic circuit comprising a first input coupled to the first measurement coil and a first output coupled to the measurement circuit, the first electronic circuit being configured to generate a first actively processed signal based on a first sensor signal received from the first measurement coil and output the first actively processed signal from the first output; and
   a second electronic circuit comprising a second input coupled to the second measurement coil and a first output coupled to the measurement circuit, the first electronic circuit being configured to generate a second actively processed signal based on a second sensor signal received from the second measurement coil and output the second actively processed signal from the second output,
   wherein the measurement circuit is configured measure the electrical energy based on a combination of the first actively processed signal and the second actively processed signal.
22. The utility meter of clause 21, further comprising a combining circuit arranged to couple the first electronic circuit to the measurement circuit, and the second electronic circuit to the measurement circuit, wherein the combining circuit is configured to:
   generate a combined signal for outputting to the measurement circuit by combining the first actively processed signal and the second actively processed signal.

## Claims

1. A current sensor system for use in measuring an electrical measurand that is dependent on current in a current carrying conductor, the current sensor system comprising:
a first measurement coil;
a second measurement coil, wherein the first measurement coil and the second measurement coil are configured for positioning relative to each other and the current carrying conductor so as to at least partially surround the current carrying conductor;
a first electronic circuit comprising a first input coupled to the first measurement coil and a first output for coupling to a measurement circuit, the first electronic circuit being configured to generate a first actively processed signal based on a first sensor signal received from the first measurement coil and output the first actively processed signal from the first output; and
a second electronic circuit comprising a second input coupled to the second measurement coil and a first output for coupling to the measurement circuit, the first electronic circuit being configured to generate a second actively processed signal based on a second sensor signal received from the second measurement coil and output the second actively processed signal from the second output,
wherein the first actively processed signal and the second actively processed signal are for combining to measure the electrical measurand that is dependent on current in a current carrying conductor.

2. The current sensor system of claim 1, wherein the first electronic circuit comprises a first amplifier configured to generate an amplified version of the first sensor signal, and
wherein the second electronic circuit comprises a second amplifier configured to generate an amplified version of the second sensor signal.

3. The current sensor system of claim 2, wherein a gain of the first amplifier is the same as a gain of the second amplifier, a gain of the first amplifier is different to a gain of the second amplifier.

4. The current sensor system of any preceding claim, wherein at least one of the following applies:
(a) the first electronic circuit comprises a first analog to digital converter, ADC, arranged to generate a first digital signal that is dependent the first sensor signal, and wherein the second electronic circuit comprises a second analog to digital converter, ADC, arranged to generate a second digital signal that is dependent the second sensor signal;
(b) the first electronic circuit comprises a first voltage-to-current converter, wherein the first sensor signal is a voltage signal and the first voltage-to-current converter is configured to generate a first current signal that is dependent on the first sensor signal, and the second electronic circuit comprises a second voltage-to-current converter, wherein the second sensor signal is a voltage signal and the second voltage-to-current converter is configured to generate a second current signal that is dependent on the second sensor signal.

5. The current sensor system of any preceding claim, further comprising:
a combining circuit for coupling the first output of the first electronic circuit to the measurement circuit and coupling the second output of the second electronic circuit to the measurement circuit,
wherein the combining circuit is configured to generate a combined signal for outputting to the measurement circuit by combining the first actively processed signal and the second actively processed signal.

6. The current sensor system of claim 5, wherein the combining circuit is a passive circuit configured to passively combine the first actively processed signal and the second actively processed signal.

7. The current sensor system of claim 5, wherein the combining circuit is an active circuit configured to actively combine the first actively processed signal and the second actively processed signal.

8. The current sensor system of claim 7, wherein the combing circuit comprises an amplifier comprising:
inputs to receive the first actively processed signal and the second actively processed signal; and
an output to output the first combined signal.

9. The current sensor system of claim 5, wherein the combining circuit comprises a digital circuit for digitally combining the first actively processed signal and the second actively processed signal.

10. The current sensor system of any preceding claim, wherein the first measurement coil is formed on a first printed circuit board, PCB, and
wherein the second measurement coil is formed on a second PCB, and
optionally wherein the first electronic circuit is on the first PCB and the second electronic circuit is on the second PCB.

11. The current sensor system of any preceding claim, further comprising:
the measurement circuit coupled to the first electronic circuit and the second electronic circuit and configured to measure the electrical measurand that is dependent on current in the current carrying conductor based on a combination of the first actively processed signal and the second actively processed signal.

12. The current sensor system of any preceding claim, wherein the electrical measurand that is dependent on current in the current carrying conductor comprises any one or more of:
a rate of change of the current in the current carrying conductor;
an amplitude of the current in the current carrying conductor;
electrical energy associated with the current in the current carrying conductor;
electrical power associated with the current in the current carrying conductor.

13. The current sensor system of any preceding claim, wherein the first measurement coil is for subtending a first perimeter portion of the current carrying conductor; and
the second measurement coil is for subtending a second perimeter portion of the current carrying conductor; and
optionally wherein the first measurement coil and the second measurement coil are configured such that when they are in use, positioned relative to the current carrying conductor, they together subtend a combined perimeter portion of the current carrying conductor that is greater than each of the first perimeter portion and the second perimeter portion.

14. A measurement system for measuring an electrical measurand that is dependent on current in a current carrying conductor, the measurement system comprising:
a combining circuit for coupling to a first measurement coil and a second measurement coil that are arranged to at least partially surround the current carrying conductor, wherein the combining circuit is configured to generate a combined signal by combining:
a first actively processed signal that is dependent on a first sensor signal output by the first measurement coil; and
a second actively processed signal that is dependent on a second sensor signal output by the second measurement coil; and
a measurement circuit coupled to the combining circuit, wherein the measurement circuit is configured to measure the electrical measurand based on the combined signal.

15. A utility meter for measuring electrical energy supplied by a current carrying conductor, the utility meter comprising the current sensor system of any of claims 1 to 13.
